# EUROPEAN PATENT SPECIFICATION

(11) **EP 0 655 786 B1**
(45) Date of publication and mention of the grant of the patent: **08.09.1999**
(21) Application number: 94118437.6
(22) Date of filing: 23.11.1994
(51) Int. Cl.: H01L 29/423, H01L 29/78, H01L 21/336

(54) **Semiconductor device with gate electrode formed in trench and method of making the same**
Halbleiteranordnung mit tiefer gesetzter Gateelektrode und Verfahren zu deren Herstellung
Dispositif sémi-conducteur avec électrode de grille formée dans une tranchée et sa méthode de fabrication

(30) Priority: 30.11.1993 JP 32988893
(43) Date of publication of application: 31.05.1995
(73) Proprietor: SONY CORPORATION, Tokyo (JP)
(72) Inventor: Miwa, Hiroyuki, c/o Sony Corporation, Tokyo (JP)
(74) Representative: Müller, Frithjof E., Dipl.-Ing.

(56) References cited:
- PATENT ABSTRACTS OF JAPAN vol. 017 no. 640 (E-1465) ,26 November 1993 & JP-A-05 206459 (NEC CORP) 13 August 1993, & US-A-5 338 950 (MITSUMOTO HIROSHI) 16 August 1994
- PATENT ABSTRACTS OF JAPAN vol. 016 no. 255 (E-1214) ,10 June 1992 & JP-A-04 056279 (MATSUSHITA ELECTRON CORP) 24 February 1992,
- PATENT ABSTRACTS OF JAPAN vol. 011 no. 117 (E-498) ,11 April 1987 & JP-A-61 263277 (FUJITSU LTD) 21 November 1986,
- PATENT ABSTRACTS OF JAPAN vol. 016 no. 322 (E-1233) ,14 July 1992 & JP-A-04 093080 (MATSUSHITA ELECTRIC IND CO LTD) 25 March 1992,
- PATENT ABSTRACTS OF JAPAN vol. 009 no. 126 (E-318) ,31 May 1985 & JP-A-60 014471 (OKI DENKI KOGYO KK) 25 January 1985,

## Description

### BACKGROUND OF THE INVENTION

### FIELD OF THE INVENTION

The present invention relates to a method of making a semiconductor apparatus, and more particularly to an improvement in the method of making a highly efficient MOS electrode effect transistor.

### DESCRIPTION OF THE RELATED ART

An important problem which is attended with the recent miniaturization and higher efficiency of MOS electrode effect transistor is how to suppress the short channel effect. As one approach to cope with this problem a gate mounted MOS electrode effect transistor technique has been proposed.

This technique suppresses the short channel effect by digging down the silicon substrate in the channel area and increasing virtually the channel length, and furthermore, improves the hot carrier resistance by moving the channel area away from the source and drain parts.

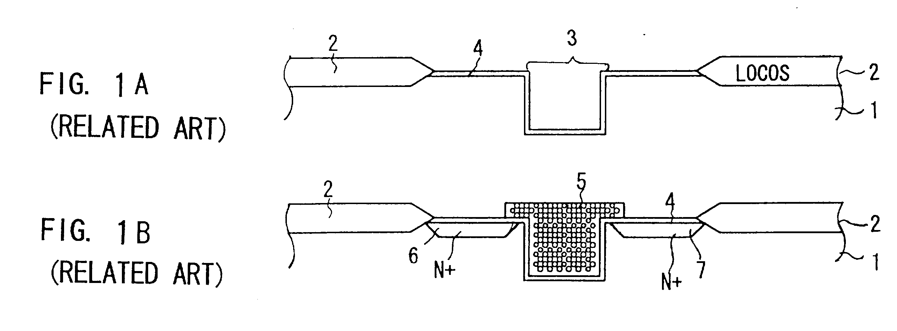

Figs. 1A and 1B show a processing flow of this technique. This is a cross sectional view of an N-channel MOS transistor formed on the silicon substrate. As shown in Fig. 1A, a LOCOS oxide film 2 for separating elements is formed on the silicon substrate 1 and then a shallow trench 3 is formed in the channel area.

Then a gate oxide film 4 is formed on the surface of the substrate including the inner part of the trench with the aid of rapid thermal technique using an oxide diffusing furnace. In this connection, the LOCOS oxide film 2 is formed with a thickness of 400 to 500 nm and the gate oxide film is formed with a thickness of 10 to 20 nm.

At this step boron ions are introduced in order to control the threshold voltage Vth.

Furthermore, as shown in Fig. 1B, an N⁺ polysilicon film of 200 to 400 nm thickness is piled up in the trench 3 and on the surface of the substrate by CVD. Then, polysilicon is processed with the aid of existing dry etching technique to form a gate electrode 5 of MOS transistor.

Then, N⁺ ions are introduced into the MOS transistor unit and a source diffusion zone 6 and a drain diffusion zone 7 are formed. Then, the source diffusion zone 6 and the drain diffusion zone 7 are activated by thermal processing and furthermore, each electrode is formed using an existing wiring technique (not shown). The MOS transistor is formed according to the procedure described above.

However, since it is necessary to fit the positions of electrode edges and the shallow trench 3 in the case of processing the gate electrode as shown in Fig. 1B, there is a possibility that the effective gate length L_{eff} varies. Therefore, there has been a problem that characteristic scattering increases and the improvement of the integration factor is thus prevented.

The JP-A-5 206 459 describes a semiconductor device including a MISFET which has a gate polysilicon between source and drain regions, the gate polysilicon being covered with a gate insulator film. The gate polysilicon with the gate insulator film thereon has a protruded curved bottom portion extending in the substrate direction. The ion implantation for forming the source and drain regions is performed by using a protruded gate portion as a mask. The source and drain regions are formed by first forming a first shallow region using a vertical low energy ion implantation and then, after formation of a gate sidewall film, forming a second deep region using a vertical high energy ion implantation.

In the JP-A-4 056 279 a method is described for making a transistor symmetrical in characteristics and to enable transistors to vary little in characteristics by a method wherein a groove and a polysilicon gate electrode are patterned through a single mask.

The JP-A-61 263 277 discloses a method to suppress the short channel effect by coating an insulating layer on a substrate to form a gate in a recess on the substrate and then performing the step of forming a groove on the substrate through the insulating layer on a gate electrode forming region to reduce source and drain resistance.

According to the JP-A-4 093 080 an inverter T-shaped gate electrode is formed on a groove by etching a first film formed on a semiconductor layer and the layer through a gate oxide film to eliminate the thinning of a pattern of a gate electrode and to reduce an electric resistance.

### SUMMARY OF THE INVENTION

In view of the foregoing, an object of the present invention is to provide a method of making a semiconductor apparatus which is capable of forming a mounted-type MOS transistor having high performance characteristic and having no fear of effective gate length changes.

The foregoing object and other objects of the invention have been achieved by the features of the appended claim 1.

A semiconductor apparatus fabricated according to the invention comprises: a trench 3 formed in the direction of depth from the surface of a semiconductor substrate 1; an electric conduction film 14 (15, 16) formed on the inside surface of the trench 3; and impurity diffusion zones 17, 18 formed inside of the semiconductor substrate 1 and having equal distances from respective edges of the electric conduction film 14 (15, 16).

According to the present invention, the method of making the semiconductor apparatus comprises the process steps of the appended claim 1.

The edge of the first and/or second electric conduction films 14, 15, and/or 16 can be determined by self adjustment with respect to the trench 3. On the occasion of obtaining the highly efficient MOS electrode effect transistor having mounted gate, positions of the source and trench for the channel part can be determined by self adjustment and fluctuation of the effective channel length L_{eff} can be avoided and integratability can be improved.

The nature, principle and utility of the invention will become more apparent from the following detailed description when read in conjunction with the accompanying drawings in which like parts are designated by like reference numerals or characters.

### BRIEF DESCRIPTION OF THE DRAWINGS

In the accompanying drawings:

Figs. 1A and 1B are schematic diagrams explaining a conventional method of making the semiconductor apparatus.

Figs. 2A to 2C are schematic diagrams showing one embodiment of the semiconductor apparatus and a method of making thereof according to the present invention.

### DETAILED DESCRIPTION OF THE EMBODIMENT

Preferred embodiments of the present invention will be described with reference to the accompanying drawings:

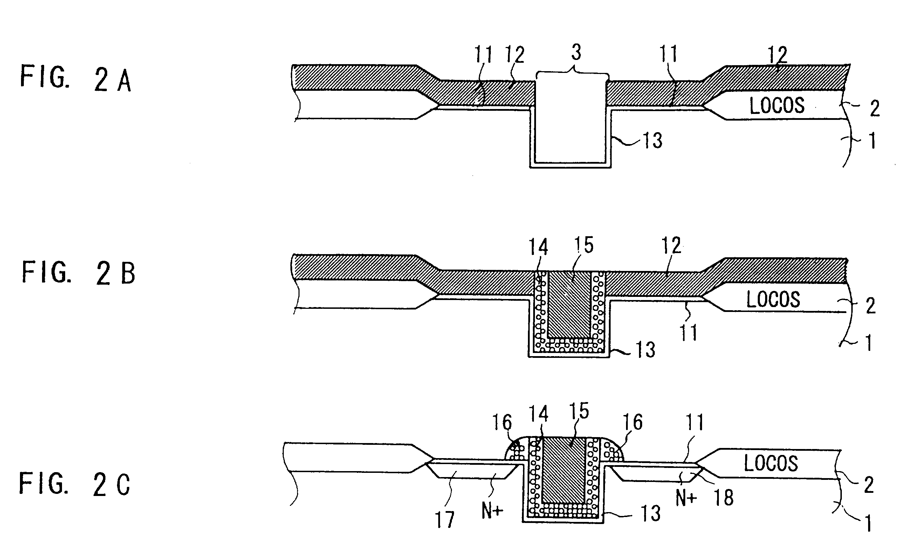

Figs. 2A to 2C, in which corresponding parts of Figs. 1A and 1B are given the same reference numerals, show cross sectional views of an N channel MOS transistor formed on a silicon substrate. The making process is hereinafter described successively with reference to the figures. As shown in Fig. 2A, a LOCOS oxide film 2 for separating elements is formed on the silicon substrate 1 and then, the first gate oxide film 11 is formed in the element forming area.

Then, after forming the silicon nitride film 12 on the entire surface of wafer by CVD, the channel area is opened using the lithographic technique and etching is conducted successively from the upper surface, the silicon nitride film 12, the first gate oxide film 11, and the silicon substrate 1 using the existing dry etching technique. Thus, a shallow trench 3 is formed.

Then, the second gate oxide film 13 is formed on the inside wall of the shallow trench 3 using a rapid thermal technique by an oxide diffusing furnace.

In this connection, a LOCOS oxide film 2 is formed with a thickness of 400 to 500 nm and gate oxide films 11 and 13 are formed with a thickness of 10 to 20 nm. At this point, boron ions are introduced in order to control the threshold voltage Vth.

Then, as shown in Fig. 2B, an N⁺ polysilicon film 14 with a thickness of 100 to 200 nm and a tungsten silicon film (WSix) 15 are piled inside of the shallow trench 3 using the CVD method. And then, the polysilicon film 14 and the tungsten silicon film (WSix) 15 protruded to the upper part of the shallow trench 3 is removed by a chemical mechanical polishing technique using the silicon nitride film 12 formed before as an etching stopper.

As shown in Fig. 2C, the silicon nitride film 12 covering around the shallow trench 3 is removed by using the existing dry etching technique. Regarding the etching being used in this case, the condition in which high selective ratio can be obtained for the gate oxide film 11 is adopted.

Then, the polysilicon film is piled on the entire surface of wafer once by CVD. Then, the anisotropic etching is conducted on the polysilicon film, and the side wall 16 is formed on the side wall of polysilicon film 14. And the distance between the edge of shallow trench 3 and the source and drain diffusion zone can be arbitrarily set according to the thickness (width) of the side wall 16.

Hereafter, N⁺ ions are injected in the MOS transistor part, to form the source diffusion zone 17 and the drain diffusion zone 18. Then, the source diffusion zone 17 and the drain diffusion zone 18 are activated by the thermal processing and each electrode is formed using the existing wiring technique (not shown). With this arrangement, the gate-mounted type MOS transistor is formed.

According to the foregoing processing, the gate electrode is formed with the electric conduction films 14 and 15 mounted in the shallow trench 3, so that the gate electrode can be formed by self-adjustment for the shallow trench 3. Also, since N⁺ ions are injected using the side wall 16 as a mask to form the source diffusion zone 17 and the drain diffusion zone 18, positions of the source diffusion zone 17 and the drain diffusion zone 18 to the channel part can be decided by self-adjustment.

Accordingly, the conventional problem that the effective channel length L_{eff} changes due to the position shift between the edge of gate electrode and the edge of shallow trench 3 can be avoided. Also, the integratability can be improved by eliminating margins of the position matching.

Furthermore, in the embodiment described above, the case of N channel MOS transistor is described. However, the present invention is not only limited to this, but also is applicable to the case of P channel MOS transistor.

Moreover, in the embodiment described above, the gate electrode is formed with the polysilicon film 14 and the tungsten silicon film (WSix) 15. However, the present invention is not only limited to this, but also it may be formed of silicon, polysilicon, a-silicon and/or laminated films including these.

Furthermore, the first and second gate oxide films 11 and 13 may be formed of the other insulation films. Similarly, in the embodiment described above, the silicon nitride film 12 is laminated on the surface of the first gate oxide film 11. However, the present invention is not only limited to this, but may laminate the other thin films having high etching selectivity ratio to the lower zone.

According to the present invention as described above, since it is so arranged that the edge of the first and/or second electric conduction films can be formed by self adjustment to the trench and also the position of the edge of impurity diffusion zone can be formed by self adjustment to the edge of electric conduction film, the effective length of conduction zone can be controlled almost constant. Thus, a semiconductor apparatus having higher performance as compared with the past can be realized.

While there has been described in connection with the preferred embodiments of the invention, it will be obvious to those skilled in the art that various changes and modifications may be aimed, therefore, to cover in the appended claims all such changes and modifications as fall within the scope of the invention.

## Claims

1. A method of making a semiconductor apparatus, comprising:
a process for forming a first insulation film (11) on the semiconductor substrate (1);
a process for forming a first thin film (12) on said first insulation film (11);
a process for etching said semiconductor substrate (1) over said first thin film (12) and said first insulation film (11) to form a trench (3) in the direction of depth from the surface of the semiconductor substrate (1);
a process for forming a second insulation film (13) along the inside wall of said trench (3);
a process for forming a first electric conduction film (14, 15) inside of said second insulation film (13) and forming an embedded electrode in said trench (3);
a process for removing said first thin film (12);
a process for forming a second electric conduction film (16) directlv contacting the side wall of the first electric conduction film (14, 15) projecting up from the surface of said first insulation film (11) in said first electric conduction film, said forming process being performed by depositing said second electric conduction film (16) on the entire surface of the wafer and then conducting anisotropic etching on said second electric conduction film (16), and thereafter
a process for introducing impurities to the inside of said semiconductor substrate (1) using said first and second electric conduction films (14, 15, 16) as masks, wherein no impurities are introduced to the inside of said semiconductor substrate before the forming of the first and second electric conduction films (14, 15, 16).

2. A method of making the semiconductor apparatus, according to claim 1, wherein
the etching resistance of said first thin film (12) on said first insulation film (11) is different from that of said first insulation film;
and before the process for removing said first thin film (12) a process for remaining said first electric conduction film (14,15) only in said trench (3) is conducted by a chemical mechanical polishing technique using said first thin film (12) as an etching stopper.

3. A method of making the semiconductor apparatus according to claim 1 or 2, wherein;
said first and/or said second electric conduction films (14,15,16) are formed of laminated films consisting of Si, Poly-Si, a-Si, and/or laminated films including these.

## Patentansprüche

1. Verfahren zum Herstellen eines Halbleiterbauteils, mit:
- einem Prozess zum Herstellen eines ersten Isolierfilms (11) auf dem Halbleitersubstrat (1);
- einem Prozess zum Herstellen eines ersten Dünnfilms (12) auf dem ersten Isolierfilm (11);
- einem Prozess zum Ätzen des Halbleitersubstrats (1) über dem ersten Dünnfilm (12) und dem ersten Isolierfilm (11) zum Herstellen eines Grabens (3) in der Tiefenrichtung ausgehend von der Fläche des Halbleitersubstrats (1);
- einem Prozess zum Herstellen eines zweiten Isolierfilms (13) entlang der Innenwand des Grabens (3);
- einem Prozess zum Herstellen eines ersten elektrisch leitenden Films (14, 15) innerhalb des zweiten Isolierfilms (13) und zum Herstellen einer eingebetteten Elektrode in diesem Graben (3);
- einem Prozess zum Entfernen des ersten Dünnfilms (12);
- einem Prozess zum Herstellen eines zweiten elektrisch leitenden Films (16), der unmittelbar mit der Seitenwand des ersten elektrisch leitenden Films (14, 15) in Kontakt steht, die von der Oberfläche des ersten Isolierfilms (11) im ersten elektrisch leitenden Film hochsteht, wobei der Herstell-prozess dadurch ausgeführt wird, dass der zweite elektrisch leitende Film (16) auf der gesamten Fläche des Wafers abgeschieden wird und dann an diesem zweiten elektrisch leitenden Film (16) ein anisotroper Ätzvorgang ausgeführt wird, und anschließend
- einem Prozess zum Einführen von Fremdstoffen in das Innere des Halbleitersubstrats (1) unter Verwendung des ersten und zweiten elektrisch leitenden Films (14, 15, 16) als Masken, wobei vor dem Herstellen des ersten und zweiten elektrisch leitenden Films (14, 15, 16) keine Fremdstoffe in das Innere des Halbleitersubstrats eingeführt werden.

2. Verfahren zum Herstellen des Halbleiterbauteils nach Anspruch 1, bei dem
- die Ätzbeständigkeit des ersten Dünnfilms (12) auf dem ersten Isolierfilm (11) von der des ersten Isolierfilms verschieden ist;
- und vor dem Prozess des Entfernens des ersten Dünnfilms (12) ein Prozess zum Belassen des ersten elektrisch leitenden Films (14, 15) nur im Graben (3) durch eine chemischmechanische Poliertechnik unter Verwendung des ersten Dünnfilms (12) als Ätzstopper ausgeführt wird.

3. Verfahren zum Herstellen des Halbleiterbauteils nach Anspruch 1 oder Anspruch 2, bei dem der erste und/oder zweite elektrisch leitende Film (14, 15, 16) aus Laminatfilmen hergestellt werden, die aus Si, Poly-Si, a-Si und/oder Laminatfilmen, die diese Materialien enthalten, bestehen.

## Revendications

1. Procédé de fabrication d'un dispositif à semiconducteur comprenant :
un processus pour former un premier film d'isolation (11) sur le substrat semiconducteur (1);
un processus pour former un premier film mince (12) sur ledit premier film d'isolation (11) ;
un processus pour graver ledit substrat semiconducteur (1) par l'intermédiaire dudit premier film mince (12) et dudit premier film d'isolation (11) afin de former une tranchée (3) suivant la direction de profondeur depuis la surface du substrat semiconducteur (1) ;
un processus pour former un second film d'isolation (13) le long de la paroi interne de ladite tranchée (3) ;
un processus pour former un premier film de conduction électrique (14, 15) à l'intérieur dudit second film d'isolation (13) et pour former une électrode noyée dans ladite tranchée (3) ;
un processus pour ôter ledit premier film mince (12) ;
un processus pour former un second film de conduction électrique (16) qui entre directement en contact avec la paroi latérale du premier film de conduction électrique (14, 15) en faisant saillie depuis la surface dudit premier film d'isolation (11) dans ledit premier film de conduction électrique, ledit processus de formation étant réalisé en déposant ledit second film de conduction électrique (16) sur la totalité de la surface de la plaquette puis en mettant en oeuvre une gravure anisotrope sur ledit second film de conduction électrique (16) ; et ensuite
un processus pour introduire des impuretés à l'intérieur dudit substrat semiconducteur (1) en utilisant lesdits premier et second films de conduction électrique (14, 15, 16) en tant que masques, où aucune impureté n'est introduite à l'intérieur dudit substrat semiconducteur avant la formation des premier et second films de conduction électrique (14, 15, 16).

2. Procédé de fabrication du dispositif à semiconducteur selon la revendication 1, dans lequel :
la résistance à la gravure dudit premier film mince (12) sur ledit premier film d'isolation (11) est différente de celle dudit premier film d'isolation, et avant le processus d'enlèvement dudit premier film mince (12), un processus pour faire en sorte que ledit premier film de conduction électrique (14, 15) subsiste seulement dans ladite tranchée (3) est mis en oeuvre au moyen d'une technique de polissage chimico-mécanique en utilisant ledit premier film mince (12) en tant qu'arrêt de gravure.

3. Procédé de fabrication du dispositif à semiconducteur selon la revendication 1 ou 2, dans lequel :
ledit premier et/ou ledit second films de conduction électrique (14, 15, 16) sont formés par des films empilés constitués par du Si, du Si polycristallin, du Si amorphe et/ou par des films empilés incluant ces éléments.
